**Europäisches Patentamt**

**European Patent Office**

**Office européen des brevets**

(11) Veröffentlichungsnummer: **0 060 920**
**A2**

# (12) EUROPÄISCHE PATENTANMELDUNG

(21) Anmeldenummer: 81108302.1

(22) Anmeldetag: 14.10.81

(51) Int. Cl.³: **G 01 R 21/00**

(30) Priorität: 21.03.81 DE 3111202

(43) Veröffentlichungstag der Anmeldung:
29.09.82 Patentblatt 82/39

(84) Benannte Vertragsstaaten:
AT BE CH FR GB IT LI

(71) Anmelder: Felten & Guilleaume Energietechnik GmbH
Schanzenstrasse 24
D-5000 Köln 80(DE)

(72) Erfinder: Beck, Martin, Ing.-grad.
Bremer Strasse 12
D-2890 Nordenham(DE)

(72) Erfinder: Hoefert, Reimar, Dipl.-Ing.
Robinsonstrasse 15
D-2890 Nordenham(DE)

(72) Erfinder: Weitkamp, Horst, Ing.-grad.
Lübbenstrasse 7
D-2890 Nordenham(DE)

(72) Erfinder: Zielasko, Horst
Reithfelder Strasse 15
D-2890 Nordenham(DE)

(54) Schaltungsanordnung zur elektrischen Energiemessung mit Bewertung der Leistung im Tarifbereich.

(57) Die Erfindung bezieht sich auf eine Schaltungsanordnung zur elektrischen Energiemessung mit Bewertung der Leistung im Tarifbereich. Die Aufgabe besteht darin, eine bessere Kenntnis über die Benutzungscharakteristik von Haushaltsgeräten zu erhalten, um damit zu einer Optimierung des Einsatzes elektrischer Energie zu kommen. Die Lösung sieht im wesentlichen eine Kombination von 3 Schaltern für Normfaktoren (10), Leistungsstufen (11) und Bewertung (12) vor, die einem Mikrocomputer (5) zugeordnet sind. Mikrocomputer (5) und Schalter (10, 11, 12) sind die wesentlichen Bestandteile eines Zählervorschaltgerätes (2), das an einen Kilowattstundenzähler (1) angekoppelt ist. Die Erfindung wird hauptsächlich angewandt bei der Energieversorgung von Haushalten.

FIG. 2

Fl 4602            1            20.03.81

## Schaltungsanordnung zur elektrische Energiemessung mit Bewertung der Leistung im Tarifbereich

Die Erfindung bezieht sich auf eine Schaltungsanordnung zur elektrischen Energiemessung mit Bewertung der Leistung im Tarifbereich gemäß dem Oberbegriff des Anspruchs 1.

In jüngster Zeit verstärken sich die Bestrebungen, im Bereich der elektrischen Energieversorgung zu einer zeitlich konstanten Leistungsbeanspruchung zu gelangen. Die Elektrizitätsversorgungsunternehmen (EVU) haben hierzu begrenzte Möglichkeiten, um über die Tarifpolitik gestaltend eingreifen zu können. Hierzu gehören z.B. die zeitabhängigen Tarife, auch als Hoch- und Niedrig-Tarife bekannt, die den Bezug elektrischer Energie zu bestimmten Zeiten verteuern. Diese Maßnahme trifft nun alle Verbraucher gleichmäßig, unabhängig davon, ob der einzelne Verbraucher zur Zeit des Hochtarifs wenig oder viel elektrische Energie bezieht. Es besteht aber auch die Möglichkeit, eine direkte Verrechnung der Leistungsbeanspruchung vorzunehmen, wie es mit dem Maximum- und Überverbrauchstarif geschieht.

Als Maximumtarif wird die im Laufe eines Zeitabschnitts während einer bestimmten Zeit aufgetretene mittlere Höchstbelastung in kW für die Berechnung des Grundpreises herangezogen. Der hierzu erforderliche Maximumzähler muß somit außer dem Arbeitsverbrauch in kWh auch die mittlere Höchstlast in kW anzeigen. Beim Überverbrauchstarif werden Zähler eingesetzt, die den Gesamtverbrauch und den Überverbrauch getrennt ausweisen. Das Überverbrauchszählwerk zeigt diejenigen kWh an,
die mit einer Leistung ein zuvor bestimmtes Limit überschreiten. Beide Zählerarten werden den gestiegenen Anforderungen
jedoch nur in unzureichendem Maße gerecht, zumal die Einsatzmöglichkeiten bei den vorwiegend mechanischen Zählern sich
nur von Fall zu Fall bestimmen lassen, abgesehen von den Einflüssen der entsprechenden Einrichtungen auf den Zählerrotor.
Die Verwendung von Mikrocomputern schafft hier neue Anwendungsgebiete. So ist bereits ein Maximumzähler bekannt, der
sich der Mikrocomputertechnik bedient (DE-AS 26 13 112). Der
hier beschriebene Maximumzähler weist zur Auswertung der impulsförmig angebotenen Angaben über den Energieverbrauch
einen Mikrocomputer auf. Hierbei stellte sich später heraus,
daß der Einsatz eines Mikrocomputers nur dann lohnend erscheint, wenn nicht nur die bisherige Mechanik ersetzt wird,
sondern zusätzliche Funktionen erfüllt werden (DE-OS 27 47 406).
Die hier beschriebene elektronische Maximum-Meßeinrichtung
weist ein Maximumwerk mit fester und ein Maximumwerk mit
gleitender Meßperiode in ein- und demselben Mikrocomputer auf.
Zusätzlich wird hier ein Schieberegister benötigt und eine
etwas anders geartete Programmierung des Mikrocomputers, um
beide Funktionen erfüllen zu können. Mit Hilfe dieser elektronischen Maximum-Meßeinrichtung ist es möglich, das Maximum
mit einer festen Meßperiode oder mit einer gleitenden Meßperiode gleichzeitig oder wechselweise zu erfassen. Aus tarifpoliti-schen Gründen vermag der Maximumzähler allerdings oft
nicht zu befriedigen.

Der Erfindung liegt daher die Aufgabe zugrunde, eine Schaltungsanordnung zur elektrischen Energiemessung mit Bewertung
der Leistung im Tarifbereich zu entwickeln, um eine bessere
Kenntnis über die Benutzungscharakteristik von Haushaltsgeräten als bisher zu erhalten und zu einer Optimierung des Einsatzes elektrischer Energie zu kommen, wobei die Schaltungsanordnung von den EVU's universell einsetzbar sein und dem
Verbraucher eine stetige Kontrolle seines Energieverbrauchs
ermöglichen soll.

Diese Aufgabe wird erfindungsgemäß durch die im Kennzeichen des Anspruchs 1 angegebene Kombination von Merkmalen gelöst.

Die mit der Erfindung erzielten Vorteile bestehen darin, daß es nun möglich ist, eine zusätzliche Bewertung der entnommenen Energie in Abhängigkeit der gelieferten Leistung vorzunehmen, wobei verschiedene Leistungsstufen mit Bewertungsfaktoren vorgegeben sind. Dem Kunden wird damit eine Entscheidungshilfe an die Hand gegeben, durch Abschalten von Geräten in einen günstigeren Tarif zu kommen. Den EVU's gereicht es zum Vorteil, daß alle wesentlichen Zählertypen mit der erfindungsgemäßen Schaltungsanordnung ohne Änderung derselben bedient werden können. Je kleiner das Meßintervall gewählt wird, umso größer ist der Vorteil für den Verbraucher, da der gemessene Verbrauch dem wirklichen Verbrauch mit einem kleinen Zeitfehler entspricht.

Vorteilhafte Ausgestaltungen und Weiterbildungen des Gegenstandes nach Anspruch 1 sind den Unteransprüchen zu entnehmen.

Durch die Unterteilung der Leistungsstufen in wenigstens 8 Reihen besteht die Möglichkeit, durch eine Vervielfachung dieser Reihen ein breites Spektrum der Leistung abzudecken. (Anspruch 4). Hierbei kann man vorteilhafterweise die Reihen derart abstufen, daß Werte von $\geq$ 0,25 kW einstellbar sind. - Ähnlich kann man mit den Bewertungsstufen verfahren, die man zweckmäßigerweise ebenfalls in wenigstens 8 Reihen unterteilt, wobei die Reihen unter Berücksichtigung spezieller Wünsche und Anregungen der EVU's aufgestellt und abgestuft sind (Anspruch 5). Damit ist der Vorteil verbunden, das Tarifgeschehen variabel zu gestalten. - Auch ist es vorgesehen, einen Verbraucher bei Überschreiten eines bestimmten Wertes netzseitig abzutrennen, was zweckmäßigerweise über einen Leistungsschalter geschieht (Anspruch 7). Damit kann einer eventuellen Überlastung des Stromnetzes vorgebeugt werden, indem Verbraucher vorübergehend vom Energiebezug ausgeschlossen werden.

- Damit der Kunde sich jeweils auf eine neue Situation beim
Energiebezug einstellen kann, ist eine "Freileistung" und
eine "Vorwarnzeit" vorgesehen, wobei die Anzeigeeinrichtung
mit der betreffenden Tarifierungsstufe blinkt (Anspruch 8).
Die "Freileistung" und die "Vorwarnzeit" können nach Bedarf
festgelegt werden. Hierbei kann z.B. die Freileistung von
0-2 kW variieren, wobei im letzteren Fall der Kunde die Möglichkeit hat, wenigstens ein Großgerät von 2 kW zu betreiben,
ohne hierbei höher bewertet zu werden. Nur bei Überschreiten
der "Freileistung" und der "Vorwarnzeit" wird der Verbraucher
nach Leistungsstufe und Bewertungsfaktor veranlagt. - Es erweist sich letzten Endes als vorteilhaft, die Komponenten der
Schaltungsanordnung zu einer gemeinsamen Baueinheit zusammenzufassen. Ein derartiges "Zählervorschaltgerät" läßt sich
ohne Schwierigkeiten in der Nähe des Kilowattstundenzählers
unterbringen, wobei dieses Gerät lediglich an den Impulsausgang des elektrischen Zählers anzuschließen ist.

Ein Ausführungsbeispiel der Erfindung ist in Blockschaltbildern dargestellt und wird im folgenden näher erläutert. Es
zeigen:
Fig. 1 den Einsatz eines Zählervorschaltgerätes zwischen einem
        herkömmlichen Kilowattstundenzähler und dem Verbraucher

Fig. 2 Einzelheiten des Zählervorschaltgerätes.

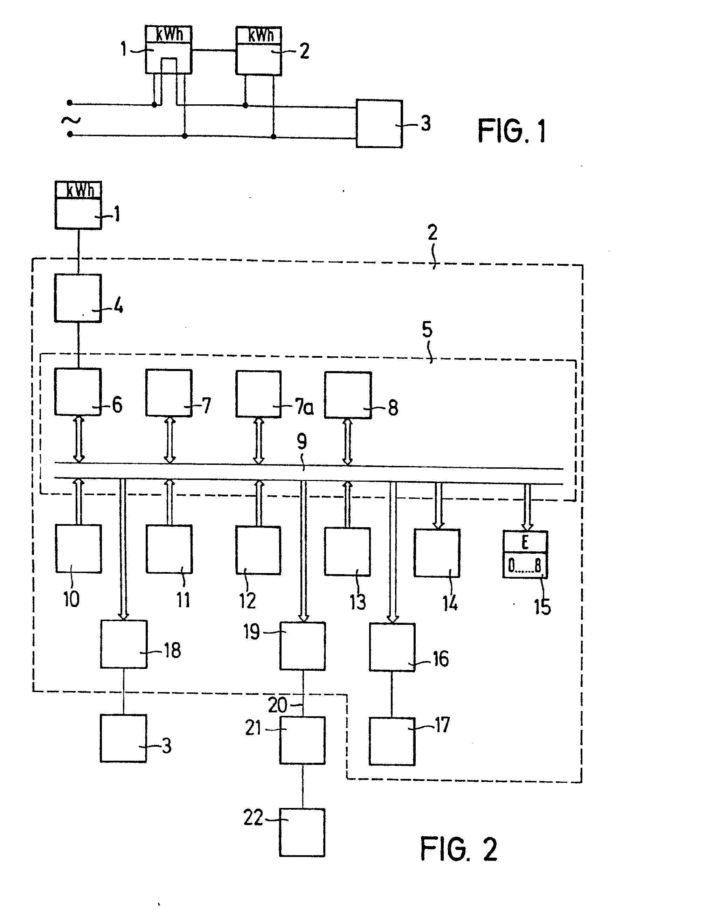

Wie Fig. 1 zeigt, ist eingangsseitig eines Stromnetzes ein
Kilowattstundenzähler 1 vorgesehen, der in direkter Verbindung
mit dem Zählervorschaltgerät 2 steht. Am Ende des Stromnetzes
ist ein Verbraucher 3 angeschaltet, der aus einer Reihe von
elektrischen Geräten bestehen möge.

Nach Fig. 2 ist der Kilowattstundenzähler 1 mit einer induktiven Ankopplungsspule versehen, die eine bestimmte Anzahl von
Impulsen pro Umdrehung an eine elektronische Schnittstelle 4
liefert. Diese elektronische Schnittstelle steht in unmittelbarem Zusammenhang mit einem Mikrocomputer 5, dessen wichtigste Bestandteile ein Mikroprozessor 6, ein Festwertspeicher 7,
ein Datenspeicher 7a, eine Ein-/Ausgabe 8 und ein Datenbus 9
sind. Im Festwertspeicher des Mikrocomputers sind tabellenmäßig mehrere Zählertypen abgelegt, die über drei Eingangsleitungen mit einem Normfaktorschalter 10 angesprochen werden können. Es sind ferner acht verschiedene Leistungsstufenreihen in einer Tabelle im Festwertspeicher des Mikrocomputers abgelegt. Die Tabellenreihen können wiederum mit einem Schalter, hier Tarifierungsschalter 11, angesprochen werden. Außerdem gibt es noch eine gleichartige Tabelle für Bewertungsfaktoren, die ebenfalls über drei Datenleitungen eingestellt werden. Der Wahlschalter hierfür ist der Bewertungsschalter 12.

Das Zählervorschaltgerät wird über eine Rundsteueranlage aktiviert, wozu ein Rundsteuerempfänger 13 oder eine Zeituhr vorgesehen ist. Dem Kunden wird ein Leistungsfreibetrag von z.B. 2 kW eingeräumt. Nur die darüber liegende Energie wird entsprechend höher bewertet und auf einem zusätzlichen elektromechanischen Zähler 14 gespeichert. Eine Anzeigeeinrichtung 15, die eine Anzeige "E" und eine Anzeige "0-8" aufweist, signalisiert dem Kunden folgende Betriebszustände:

1. Aktivierung des Zählervorschaltgerätes durch einen Rundsteuerempfänger oder eine Zeituhr: Anzeigesignal "E".

2. Bei vorhandener Aktivierung des Zählervorschaltgerätes, einer Verbraucherbelastung größer als die Grundlast und laufender Vorwarnzeit: 7-Segment-Anzeige blinkt mit der entsprechenden Tarifierungsstufe.

3. Vorwarnzeit abgelaufen und Verbraucherbelastung größer als die Grundlast: 7-Segment-Anzeige blinkt mit der betreffenden Tarifierungsstufe 0-8.

4. Rundsteuersignal vorhanden: blinkendes Signal "E".

Das Zählervorschaltgerät hat einen digitalen 8 bit breiten Datenbus, über den die gemessene oder die bewertete Leistung herausgegeben wird. Der Datenbus ist über einen D/A-Wandler 16 mit einem Registriergerät 17 verbunden. Auf diesem Registriergerät werden in Verbindung mit einer Steuerleitung zwei Kurven dargestellt. Die eine Kurve zeigt dabei die bewertete, während die andere die tatsächlich verbrauchte Leistung darstellt. Somit ist es möglich, die Benutzungscharakteristik von Haushaltsgeräten über einen bestimmten Zeitraum festzustellen.

Weiterhin ist es möglich, Verbraucher mit einem hohen Leistungsbedarf zeitweise durch einen Leistungsschalter 18 abzuschalten, falls die gesamte Leistungsentnahme einen bestimmten Wert überschreitet.

Da sich der Kilowattstundenzähler und somit auch das Zählervorschaltgerät in der Regel im Keller oder im Treppenhaus eines Hauses befinden, sich der Kunde jedoch meistens in seiner Wohnung aufhält, ist vorgesehen, die am Zählervorschaltgerät erscheinenden Informationen in die Wohnung des Verbrauchers zu übertragen. Hierzu dient ein Sender 19, der über eine Netzleitung 20 seine Informationen an einen in der Wohnung aufgestellten Empfänger 21 gibt. Auf einer Anzeigeeinrichtung 22, die der 7-Segment-Anzeige 15 entspricht, wird die Information wiederum sichtbar gemacht.

Patentansprüche:

1. Schaltungsanordnung zur elektrischen Energiemessung mit
   Bewertung der Leistung im Tarifbereich, bei der die von der
   Drehscheibe eines Kilowattstundenzählers (1) gelieferten
   Impulse in einen Mikrocomputer (5) eingegeben werden, von
   dessem Speicher (7) ausgewertet und anschließend in Form
   von Zahlenwerten für eine Anzeigeeinrichtung (15) ausgegeben werden, d a d u r c h   g e k e n n z e i c h n e t,
   daß

   a) der Mikrocomputer über eine elektronische Schnittstelle
      (4) an eine induktive Spule des Kilowattstundenzählers
      angekoppelt ist, die eine bestimmte Anzahl von Impulsen
      pro Umdrehung an die Schnittstelle liefert,

   b) der Mikrocomputer über einen Schalter (10) für Normfaktoren an verschiedene Zählertypen anschließbar ist, wobei eine Anzahl von Zählertypen in einem Festwertspeicher (7) des Mikrocomputers abgelegt ist,

   c) verschiedene Leistungsstufen vorgesehen sind, die
      als Reihen im Festwertspeicher des Mikrocomputers abgelegt sind und über einen Schalter (11) für Tarifierung
      ansprechbar sind,

   d) der Mikrocomputer in gleicher Weise Reihen mit Bewertungsfaktoren aufweist, die mittels eines Schalters (12)
      für die Bewertung einstellbar sind, und

   e) die nach Normfaktor, Leistungsstufe und Bewertungsfaktor
      zusätzlich bewertete Leistung jeweils nach einem Meßinterwall an die Anzeigeeinrichtung (15, 22) ausgegeben wird.

2. Schaltungsanordnung nach Anspruch 1, d a d u r c h g e k e n n z e i c h n e t, daß die einzelnen Schalter ( 10, 11, 12) für Normfaktoren, Tarifierung und Bewertung als Stufenschalter ausgebildet und jeweils über drei Datenleitungen mit dem Festwertspeicher (7) des Mikrocomputers (5) verbunden sind.

3. Schaltungsanordnung nach einem der Ansprüche 1 oder 2, d a d u r c h g e k e n n z e i c h n e t, daß jeder Mikrocomputer (5) an einen Rundsteuerempfänger (13) oder an eine Zeituhr angeschlossen ist, die während der Hochlastzeit des zugehörigen EVU's ein Einschaltsignal an die Mikrocomputer geben.

4. Schaltungsanordnung nach einem der Ansprüche 1 bis 3, d a d u r c h g e k e n n z e i c h n e t, daß die Leistungsstufen in wenigstens acht Reihen unterteilt sind, deren niedrigster Wert beispielsweise mit 2 kW und deren höchster Wert beispielsweise im Bereich zwischen 30 und 50 kW festgelegt sind, wobei als niedrigste Abstufung ein Wert $\geq$ 0,25 kW einstellbar ist.

5. Schaltungsanordnung nach einem der Ansprüche 1 bis 4, d a d u r c h g e k e n n z e i c h n e t, daß die Bewertungsstufen gleichfalls in wenigstens acht Reihen unterteilt sind, die nach unterschiedlichen Gesichtspunkten aufgestellt und abgestuft sind.

6. Schaltungsanordnung nach einem der Ansprüche 1 bis 5, d a d u r c h g e k e n n z e i c h n e t, daß der Betriebszustand des Mikrocomputers und die Anzeige der Leistungsstufen auf einer 7-Segment-LED-Anzeige (15) sichtbar sind, die die Stufen mit entsprechenden Ziffern anzeigt.

7. Schaltungsanordnung nach einem der Ansprüche 1 bis 6,
d a d u r c h   g e k e n n z e i c h n e t, daß der
Mikrocomputer (5) mit einem Leistungsschalter (18) verbunden ist, der auf einen bestimmten Wert derart eingestellt
ist, daß ein Verbraucher bei Überschreiten dieses Wertes netzseitig zeitweise abtrennbar ist.

8. Schaltungsanordnung nach einem der Ansprüche 1 bis 7,
d a d u r c h   g e k e n n z e i c h n e t, daß der
Mikrocomputer (5) auf eine bestimmte "Freileistung",
z.B. 2 kW, und eine bestimmte "Freizeit", z.B. 15 Min.
einstellbar ist, wobei die Anzeigeeinrichtung (15) den
Betriebszustand "Freizeit" bzw. "Meßzeit" durch Blinken
bzw. Dauerleuchten anzeigt.

9. Schaltungsanordnung nach einem der Ansprüche 1 bis 8,
d a d u r c h   g e k e n n z e i c h n e t, daß ein
weiterer Mikrocomputer gleichen Typs im Rundsteuerempfänger (13) zur Dekodierung des Rundsteuersignals eingesetzt ist.

10. Schaltungsanordnung nach einem der Ansprüche 1 bis 9,
d a d u r c h   g e k e n n z e i c h   n e t, daß der
Mikrocomputer (5) einen digitalen 8 bit Datenbus (9)
aufweist, über den die gemessene und/oder bewertete
Leistung herausgegeben wird.

11. Schaltungsanordnung nach einem der Ansprüche 1 bis 10,
d a d u r c h   g e k e n n z e i c h n e t, daß der
Datenbus (9) mit einem elektromechanischen Zähler (14)
und/oder über einen Digital-Analogwandler (16) mit
einem Registriergerät (17) verbunden ist, auf denen die
Werte für die bewertete und/oder die tatsächlich verbrauchte Leistung dargestellt sind.

12. Schaltungsanordnung nach einem der Ansprüche 1 bis 11, d a d u r c h   g e k e n n z e i c h n e t, daß der Mikrocomputer (5), die Schalter (10, 11, 12, 18), der Rundsteuerempfänger (13), der Zähler (14) und die Anzeigeeinrichtung (15) zu einer Baueinheit zusammengefaßt sind, die als Zählervorschaltgerät (2) in Verbindung mit dem Kilowattstundenzähler (1) ausgebildet und unabhängig von diesem einbaubar ist.

13. Schaltungsanordnung nach einem der Ansprüche 1 bis 12, d a d u r c h   g e k e n n z e i c h n e t, daß die Anzeigeimpulse auf einen Sender (19) übertragen werden, der über die Netzleitung (20) mit einem Empfänger (21) verbunden ist, welcher die Impulse decodiert und auf eine vom Standort des Zählervorschaltgerätes (2) entferntere Anzeigeeinrichtung (22) sichtbar macht.

0060920

FIG. 1

FIG. 2